# EUROPEAN PATENT APPLICATION

(11) **EP 3 476 974 A1**
(43) Date of publication of application: **01.05.2019**
(21) Application number: 18180749.6
(22) Date of filing: 29.06.2018
(51) Int. Cl.: C23C 16/455, C23C 16/24, C23C 16/52, G05D 7/06, G01F 25/00

(54) **METHOD AND SYSTEM OF ADJUSTING PROCESS GAS FLOW OF VACUUM COATING EQUIPMENT**

(30) Priority: 27.10.2017 CN 201711024922; 13.06.2018 WO PCT/CN2018/091148
(71) Applicant: Beijing Juntai Innovation Technology Co., Ltd, 100176 Beijing (CN)
(72) Inventor: MA, Zheng, Beijing, Beijing 100176 (CN)
(74) Representative: D'Halleweyn, Nele Veerle Trees Gertrudis

(57) **Abstract**

A method of adjusting a process gas flow of a vacuum coating equipment includes: obtaining a flow set value of a process gas, and selecting a reference gas; determining a flow coefficient of the process gas relative to the reference gas; calculating a corrected flow value of the process gas according to the flow set value and the flow coefficient of the process gas; judging whether the corrected flow value of the process gas is greater than a maximum value in a range of the gas flowmeter for controlling the process gas flow, if a judgment result is yes, alarming an over range, and executing the process program with the maximum value in the range of the gas flowmeter as the flow control value of the process gas, if the judgment result is no, taking the corrected flow value as the flow control value of the process gas.

## Description

### Technical Field

The present application relates to, but is not limited to, the technical field of solar cell preparation and, in particular to, but is not limited to, a method and system of adjusting a process gas flow of a vacuum coating equipment.

### Background

With the continuous development of the vapor deposition technology, the Chemical Vapor Deposition (CVD) technology and the Plasma Enhanced Chemical Vapor Deposition (PECVD) technology are increasingly applied in the photovoltaic industry, mainly for the preparation of various film layers, and in particular, play a key role in amorphous silicon, silicon germanium, microcrystalline silicon-amorphous silicon stacks and various thin film solar cells.

The operating principle of the PECVD equipment is as follows: two electrode plates with a certain spacing that are parallel to each other are placed in a vacuum environment, wherein one electrode plate is connected to a radio frequency power supply and the other electrode plate is grounded, so that a radio frequency electric field is generated between the two electrode plates. The substrate to be coated is placed between the two electrode plates; the coating process gas enters between the two electrode plates and is excited into plasma under the action of the radio frequency electric field, and the plasma reacts with the surface of the substrate to form a film on the surface of the substrate.

There are many process parameters that affect the quality of products in the PECVD equipment, mainly including temperature, pressure, plasma power density, and type and flow of the process gas participating in the reaction. The type and flow of the process gas affect the type and structure of the finally formed film layer. In the process of industrial production, it is expected that multiple PECVD equipment continuously, stably operates the process to obtain an approximate coating effect so as to ensure the consistency of product specifications and the qualification rate of products. Even if multiple PECVD equipment has the same hardware configuration, due to different usage frequencies and installation and operation environments, process parameters will gradually become different after a period of use, in particular, a gas mass flowmeter for controlling the flow of the process gas. Because the mass flowmeter is greatly influenced by the installation environment, temperature, and usage, even if it is applied to the same type of PECVD equipment and provided with the same gas flow value, different coating effects will be produced. Similar problems also exist in the CVD technology carried out in the CVD equipment. How to control the same process parameter to obtain stable approximate results on vacuum coating equipment with different characteristics so as to ensure the qualification rate and the consistency of product specifications has important research significance.

### Summary

The following is an overview of the subject matter described in detail herein. This summary is not intended to limit the protection scope of the claims.

An embodiment of the present application provides a method and system of adjusting a process gas flow of a vacuum coating equipment, which are used for avoiding the problem that the qualification rate and the consistency of product specifications are easily decreased due to the abrasion of various vacuum coating equipment, the type of the process gas and the difference of the gas flowmeters when a plurality of existing vacuum coating equipment is preparing a film layer, can reduce the production cost of products, and improve the production efficiency and quality of the products.

An embodiment of the present application provides the following technical scheme:
a method of adjusting a process gas flow of a vacuum coating equipment, the method including:
obtaining a flow set value of a process gas and selecting a reference gas;
determining a flow coefficient of the process gas relative to the reference gas;
calculating a corrected flow value of the process gas according to the flow set value and the flow coefficient of the process gas; and
judging whether the corrected flow value of the process gas is greater than a maximum value of a range of a gas flowmeter for controlling the process gas flow, if a judgment result is yes, alarming an over range, and executing a process program with the maximum value in the range of the gas flowmeter as a flow control value of the process gas, if the judgment result is no, taking the corrected flow value as the flow control value of the process gas.

In this embodiment of the present application, the term "vacuum coating equipment" refers to a vacuum coating equipment in which a process gas participates in coating reaction.

In an exemplary embodiment, the method may further include:
determining a proportional relation of various process gases in the execution of the process program, according to a ratio between flow control values of various process gases.

In an exemplary embodiment, said determining a flow coefficient of the process gas relative to the reference gas includes:
obtaining a reference gas timing time required for the reference gas to enable a vacuum chamber of a vacuum coating equipment to reach a second set vacuum degree from a first set vacuum degree;
obtaining a process gas timing time required for the process gas to enable the vacuum chamber of the vacuum coating equipment to reach the second set vacuum degree from the first set vacuum degree; and
taking a ratio of the process gas timing time to the reference gas timing time as the flow coefficient of the process gas relative to the reference gas.

In an exemplary embodiment, obtaining the reference gas timing time or the process gas timing time includes the following steps:
opening a sucking valve of the vacuum chamber to exhaust gas in the vacuum chamber to reach a background vacuum degree;
closing the sucking valve, opening an inflation valve of the reference gas or the process gas, and inflating the vacuum chamber; and
starting timing when the vacuum chamber reaches the first set vacuum degree, not stopping timing until the vacuum chamber reaches the second set vacuum degree, and taking the obtained timing time as the reference gas timing time or the process gas timing time.

In an exemplary embodiment, obtaining the reference gas timing time or the process gas timing time further includes the following steps:
closing the inflation valve when the vacuum chamber reaches the second set vacuum degree; and
opening the sucking valve, and closing the sucking valve after evacuating the vacuum chamber to reach the background vacuum degree.

In an exemplary embodiment, the reference gas may be any one of the process gases.

In an exemplary embodiment, the reference gas may be any one of argon, hydrogen, oxygen, and silane.

In an exemplary embodiment, the method may further include: judging whether the flow coefficient of the process gas with respect to the reference gas is in a range of 0.8 to 1.2; if the judgment result is no, overhauling the equipment or resetting the process parameters until a re-determined flow coefficient of the process gas with respect to the reference gas is in the range of 0.8 to 1.2.

In an exemplary embodiment, the vacuum coating equipment may be a PECVD equipment or a CVD equipment.

An embodiment of the present application also provides a system of adjusting a process gas flow of a vacuum coating equipment, the system including: a setting unit, a flow coefficient determining unit, a flow correction unit, and a flow adjustment unit;
the setting unit being arranged to obtain a flow set value of a process gas and select a reference gas;
the flow coefficient determining unit being arranged to determine a flow coefficient of the process gas relative to the reference gas;
the flow correction unit being arranged to calculate a corrected flow value of the process gas according to the flow set value and the flow coefficient;
the flow adjustment unit being arranged to judge whether the corrected flow value is greater than a maximum value of a range of a gas flowmeter of the vacuum coating equipment, if a judgment result is yes, alarming an over range, and executing a process program with the maximum value in the range of the gas flowmeter as a flow control value of the process gas, if the judgment result is no, taking the corrected flow value as the flow control value of the process gas.

In an exemplary embodiment, the flow coefficient determining unit may include a first timing module and a second timing module;
the first timing module being arranged to time a reference gas timing time required for the reference gas to enable a vacuum chamber of the vacuum coating equipment to reach a second set vacuum degree from a first set vacuum degree;
the second timing module being arranged to time a process gas timing time required for the process gas to enable the vacuum chamber of the vacuum coating equipment to reach the second set vacuum degree from the first set vacuum degree.

In an exemplary embodiment, the flow coefficient determining unit may further include a vacuum degree setting unit;
the vacuum degree setting unit being arranged to set the first set vacuum degree and the second set vacuum degree.

In an exemplary embodiment, the system may further include a control module and a calculation module;
the control module being arranged to open a sucking valve of the vacuum chamber, exhausting gas in the vacuum chamber to reach a background vacuum degree; and closing the sucking valve after the vacuum chamber reaches the background vacuum degree, opening an inflation valve of the reference gas or the process gas, and inflating the vacuum chamber at a set flow;
the calculation module being arranged to determine a flow coefficient of the process gas relative to the reference gas by calculating a ratio of the process gas timing time to the reference gas timing time.

In an exemplary embodiment, the vacuum coating equipment may be a PECVD equipment or a CVD equipment.

An embodiment of the present application provides a method and system of adjusting a process gas flow of a vacuum coating equipment, and the method determines the flow control value of the process gas by determining the flow coefficient and the corrected flow value of the process gas relative to the reference gas, which can avoid the problem that the qualification rate and the consistency of product specifications are easily decreased due to the abrasion of various vacuum coating equipment, the type of process gas and the difference of gas flowmeters when a plurality of existing vacuum coating equipment is preparing a film layer, can reduce the production cost of the products, and improve the production efficiency and the quality of the products.

Other features and advantages of the present application will be set forth in the following description and, in part, will become more apparent in the description, or may be learned by carrying out the present application. The objects and other advantages of the present application may be realized and attained by the structure particularly pointed out in the description and claims.

### Brief Description of Drawings

The accompanying drawings are used to provide further understanding on the technical solution of the present application and form a part of the description, and together with the embodiments of the present application, serve to explain the technical solution of the present application and do not constitute a limitation to the technical solution of the present application. In order to more clearly illustrate the specific embodiments of the present application, the following will briefly introduce the drawings that need to be used in the embodiments.
FIG. 1 is a flowchart of a method of adjusting a process gas flow of a vacuum coating equipment according to an embodiment of the present application;
FIG. 2 is a flowchart of a method of determining a flow coefficient according to an embodiment of the present application;
FIG. 3 is a flowchart of a method of determining a timing time according to an embodiment of the present application.

### Detailed Description

In order to enable those skilled in the art to better understand the scheme of the embodiments of the present application, the embodiments of the present application will be further described in detail below with reference to the accompanying drawings. It should be noted that, if without conflict, the embodiments and features in the embodiments of the present application may be combined with each other arbitrarily.

The steps shown in the flowchart of the drawings may be performed in a computer system such as a set of computer-executable instructions. Also, although a logical sequence is shown in the flowchart, in some cases the steps shown or described may be performed in a sequence different from that herein.

The present application provides a method and system of adjusting a process gas flow of a vacuum coating equipment, determining the flow control value of the process gas by the flow coefficient and the corrected flow value of the process gas relative to the reference gas, which can avoid the problem that the qualification rate and the consistency of product specifications are easily decreased due to the usage frequency of the vacuum coating equipment, the environment, and the abrasion degree of other devices matched with the vacuum coating equipment, such as the gas flowmeter, when a plurality of existing vacuum coating equipment is preparing a film layer, can reduce the production cost of the product, and improve the production efficiency and the quality of the product.

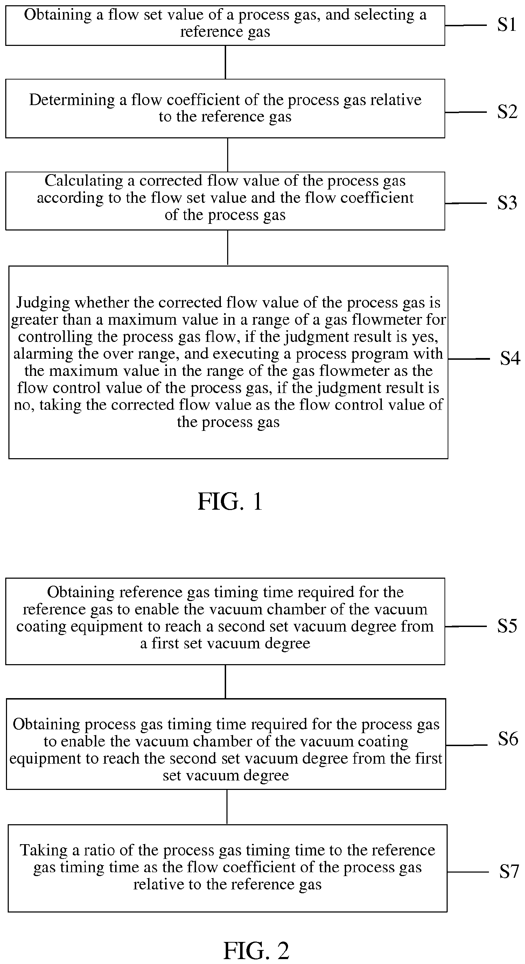

FIG. 1 is a flowchart of a method of adjusting a process gas flow of a vacuum coating equipment according to an embodiment of the present application, the method including the following steps:
S1: obtaining a flow set value of a process gas and selecting a reference gas;
S2: determining a flow coefficient of the process gas relative to the reference gas;
S3: calculating a corrected flow value of the process gas according to the flow set value and the flow coefficient of the process gas;
S4: judging whether the corrected flow value of the process gas is greater than a maximum value of a range of a gas flowmeter for controlling the process gas flow, if the judgment result is yes, alarming an over range, and executing the process program with the maximum value in the range of the gas flowmeter as the flow control value of the process gas, if the judgment result is no, taking the corrected flow value as the flow control value of the process gas.

The corrected flow value of the process gas may be equal to a product of the flow set value and the flow coefficient of the process gas. If different reference gases are selected, the values of the flow coefficients obtained may be different.

The method may further include determining the proportional relation of various process gases in the execution of the process program by the ratio between flow control values of various process gases.

In practical application, the vacuum coating equipment controls the proportional relation of various process gases in the execution of the process program through the flow control values of various process gases, that is, makes the ratio of the flow of various process gases in the execution of the process program equal to the ratio between flow control values of various process gases. The same reference gas is used to determine the flow coefficient of the various process gases of the vacuum coating equipment relative to the reference gas, and in order to enable other vacuum coating equipment to achieve the coating effect of the above vacuum coating equipment, corrected flow values of various process gases can be calculated according to the flow set value and the flow coefficient of the various process gases, the flow control values of the various process gases are determined by the gas flowmeter range corresponding to the process gas and the corrected flow values, and thereby the vacuum coating equipment controls the proportional relation of the various process gases in the vacuum chamber through the flow control values to realize the coating effect consistency of a plurality of vacuum coating equipment.

As shown in FIG. 2, said determining a flow coefficient of the process gas relative to the reference gas may include the following steps:
S5: obtaining a reference gas timing time required for the reference gas to enable the vacuum chamber of the vacuum coating equipment to reach a second set vacuum degree from a first set vacuum degree;
S6: obtaining a process gas timing time required for the process gas to enable the vacuum chamber of the vacuum coating equipment to reach the second set vacuum degree from the first set vacuum degree;
S7: taking the ratio of the process gas timing time to the reference gas timing time as the flow coefficient of the process gas relative to the reference gas.

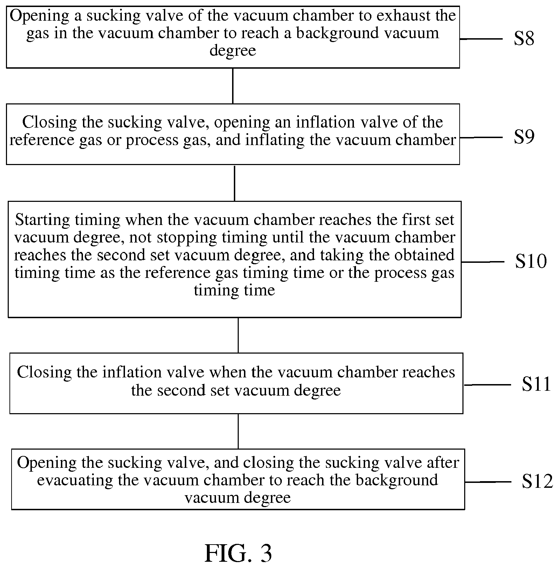

As shown in FIG. 3, obtaining the reference gas timing time or the process gas timing time may include the following steps:
S8: opening a sucking valve of the vacuum chamber to exhaust the gas in the vacuum chamber to reach the background vacuum degree;
S9: closing the sucking valve, opening the inflation valve of the reference gas or process gas, and inflating the vacuum chamber;
S10: starting timing when the vacuum chamber reaches the first set vacuum degree, not stopping timing until the vacuum chamber reaches the second set vacuum degree, and taking the obtained timing time as the reference gas timing time or the process gas timing time.

Background vacuum degree refers to a vacuum degree reached when the gas in the vacuum chamber is exhausted as far as possible, so as to avoid the subsequently introduced process gas being influenced by the gas previously existing in the vacuum chamber. The first set vacuum degree and the second set vacuum degree can be set manually. It is also possible to replace the vacuum degree with pressure, for example, the process gas timing time starts when the vacuum chamber reaches the first set pressure value by introducing the process gas and ends when the vacuum chamber reaches the second set pressure value by continuously introducing the process gas.

Obtaining the reference gas timing time or the process gas timing time may further include the following steps:
S11: closing the inflation valve when the vacuum chamber reaches the second set vacuum degree;
S12: opening the sucking valve, and closing the sucking valve after evacuating the vacuum chamber to reach the background vacuum degree.

The method may further include: determining the flow coefficient of the various process gases of the vacuum coating equipment using the same reference gas to ensure the proportion of the various process gases in the execution of the process program. In the adjustment process, the flow coefficient of the various process gases relative to the same reference gas can be determined so that various process gases use the same reference to control the flow, avoiding the influence on the flow coefficient caused by the selection of different reference gases.

In practical application, the reference gas can be any one of the process gases used by the vacuum coating equipment or any one of the following gases: argon, hydrogen, oxygen and silane. The reference gas is generally selected within the process gas range actually required by the coating process.

The method may further include: judging whether the flow coefficient of the process gas with respect to the reference gas is in the range of 0.8 to 1.2; if the judgment result is no, overhauling the equipment or resetting the process parameters until a re-determined flow coefficient of the process gas with respect to the reference gas is in the range of 0.8 to 1.2. In order to better control the gas flow of the various process gases and stabilize the flow coefficient within the range of 0.8 to 1.2, it is possible to regularly test the flow coefficients of respective process gases in the vacuum coating equipment and store said data, and the working states of the gas flowmeter and the vacuum coating equipment can be judged through the data analysis of respective process gas flow systems to ensure the quality of products, and when the flow coefficient corresponding to a certain process gas changes greatly or is not within the normal range, the relevant process gas flowmeter alarms to prevent occurrence of a large number of rejected products or unqualified products.

When the flow coefficient is not within the range of 0.8 to 1.2, the equipment needs to be overhauled to check whether the equipment hardware is damaged or whether other devices connected to the equipment are damaged, for example, whether a pressure measurement device, a flowmeter, etc. are damaged, and if the equipment hardware is correct, it is checked whether the operation is wrong or whether the equipment software part is wrong.

The vacuum coating equipment is a vacuum coating equipment in which a process gas participates in a coating reaction, and may be, for example, a PECVD equipment or a CVD equipment.

As can be seen, the present application provides a method of adjusting the process gas flow of a vacuum coating equipment, the method determining the flow control value of the process gas by determining the flow coefficient and the corrected flow value of the process gas, which can avoid the problem that the qualification rate and the consistency of product specifications are easily decreased due to the type of the process gas, the abrasion of the various vacuum coating equipment and the difference of gas flowmeters when a plurality of existing vacuum coating equipment is preparing a film layer, can reduce the production cost of the product, and improve the production efficiency and the quality of the product.

An embodiment of the present application also provides a system of adjusting a process gas flow of a vacuum coating equipment, including: a setting unit, a flow coefficient determining unit, a flow correction unit, and a flow adjustment unit. The setting unit is arranged to obtain a flow set value of a process gas and select a reference gas. The flow coefficient determining unit is arranged to determine a flow coefficient of the process gas relative to the reference gas. The flow correction unit is arranged to calculate a corrected flow value of the process gas according to the flow rate set value and the flow coefficient. The flow adjustment unit is arranged to judge whether the corrected flow value is greater than a maximum value of a range of a gas flowmeter of the vacuum coating equipment, if the judgment result is yes, alarming the over range, and executing the process program with the maximum value in the range of the gas flowmeter as the flow control value of the process gas, if the judgment result is no, taking the corrected flow value as the flow control value of the process gas.

The flow coefficient determining unit may include a first timing module and a second timing module. The first timing module is arranged to time a reference gas timing time required for the reference gas to enable the vacuum chamber of the vacuum coating equipment to reach a second set vacuum degree from a first set vacuum degree. The second timing module is arranged to time a process gas timing time required for the process gas to enable the vacuum chamber of the vacuum coating equipment to reach the second set vacuum degree from the first set vacuum degree.

The flow coefficient determining unit may further include a vacuum degree setting unit. The vacuum degree setting unit is arranged to set the first set vacuum degree and the second set vacuum degree.

The system may also include: a control module and a calculation module. The control module is arranged to open the sucking valve of the vacuum chamber and exhaust the gas in the vacuum chamber to reach the background vacuum degree; the control module is further arranged to close the sucking valve, open the inflation valve of the reference gas or process gas, and inflate the vacuum chamber at a set flow. The calculation module is arranged to determine a flow coefficient of the process gas relative to the reference gas by calculating a ratio of the process gas timing time to the reference gas timing time.

In an exemplary embodiment, the adjusting system of the process gas flow of the vacuum coating equipment provided by the present application may include a mechanical part (valve, e.g., sucking valve, inflation valve), an electric control part (e.g., programmable logic controller (PLC), a computer, etc.), and a computer program written into a programmable controller or a computer through the computer. Herein, the programmable logic controller or computer of the electric control part controls the valve to open or close according to the set parameter sequence to obtain the corresponding gas timing time; the flow coefficient is calculated by a programmable logic controller or a computer in the electric control part; when the normal process is executed by the programmable logic controller or the computer of the electric control part, the corrected flow value is loaded on the unified process parameters for individual correction.

The vacuum coating equipment is a vacuum coating equipment in which a process gas participates in a coating reaction, and may be, for example, a PECVD equipment or a CVD equipment.

It can be seen that the present application provides a system of adjusting the process gas flow of the vacuum coating equipment, obtaining the flow control value of the process gas by the flow coefficient determining unit determining the flow coefficient of the process gas relative to the reference gas, which can avoid the problem that the qualification rate and the consistency of product specifications are easily decreased due to the abrasion of various vacuum coating equipment, the type of process gas and the difference of gas flowmeters when a plurality of existing vacuum coating equipment is preparing a film layer, can reduce the production cost of the product, and improve the production efficiency and the quality of the product.

This disclosure is illustrative of the principles of examples of the present application and is not intended to limit the present application in any form or in substance, or to limit the present application to particular embodiments. It will be apparent to those skilled in the art that variations, changes, modifications, evolutions may be made to the elements, methods, and systems of the technical solutions of the examples of the present application without departing from the principles, spirit, and scope of the examples, technical solutions of the present application as defined in the claims. Embodiments of such variations, changes, modifications, and evolutions are all included within equivalent examples of the present application, which are all included within the scope as defined by the claims of the present application. Although the examples of the present application may be embodied in many different forms, what are described in detail herein are merely some embodiments of the present application. Furthermore, examples of the present application include any possible combination of some or all of the various embodiments described herein, and are also included within the scope as defined by the claims of the present application.

The above disclosure is intended to be illustrative but not exhaustive. To those skilled in the art, the description may suggest many variations and alternatives. All of such alternatives and variations are intended to be included within the scope of the present claims, wherein the term "including" means "including, but not limited to". Depiction of alternative embodiments of the present application has been completed herein. Those skilled in the art will recognize other equivalent changes to the embodiments described herein that are also encompassed by the claims appended hereto.

Those of ordinary skill in the art will understand that all or some of the steps in the method disclosed in the foregoing, systems, and functional modules/units in the device may be implemented as software, firmware, hardware, and appropriate combinations thereof. In an embodiment of hardware, the division between functional modules/units mentioned in the above depiction does not necessarily correspond to the division of physical components; for example, a physical component may have multiple functions, or a function or step may be performed by several physical components in cooperation. Some or all of the components may be implemented as software executed by a processor, such as a digital signal processor or microprocessor, or be implemented as hardware, or be implemented as integrated circuit, such as an application-specific integrated circuit. Such software may be distributed over computer readable media which may include computer storage media (or non-temporary media) and communication media (or temporary media). As known to those of ordinary skill in the art, the term computer storage medium includes volatile and nonvolatile, removable and non-removable media implemented in any method or technology for storing information such as computer readable instructions, data structures, program modules or other data. Computer storage media include, but are not limited to, RAM, ROM, EEPROM, flash memory or other memory technology, CD-ROM, digital versatile disk (DVD) or other optical disk storage, magnetic cassette, magnetic tape, magnetic disk storage or other magnetic storage device, or any other media that can be used to store desired information and can be accessed by a computer. Furthermore, it is well known to those of ordinary skill in the art that communication media typically contain computer readable instructions, data structures, program modules, or other data in a modulated data signal such as a carrier wave or other transmission mechanism, and may include any information delivery media.

## Claims

1. A method of adjusting a process gas flow of a vacuum coating equipment, the method comprising:
obtaining a flow set value of a process gas and selecting a reference gas;
determining a flow coefficient of the process gas relative to the reference gas;
calculating a corrected flow value of the process gas according to the flow set value and the flow coefficient of the process gas; and
judging whether the corrected flow value of the process gas is greater than a maximum value of a range of a gas flowmeter for controlling the process gas flow, if a judgment result is yes, alarming an over range, and executing a process program with the maximum value in the range of the gas flowmeter as a flow control value of the process gas, if the judgment result is no, taking the corrected flow value as the flow control value of the process gas.

2. The method of adjusting a process gas flow of a vacuum coating equipment according to claim 1, the method further comprising:
determining a proportional relation of various process gases in the execution of the process program, according to a ratio between flow control values of various process gases.

3. The method of adjusting a process gas flow of a vacuum coating equipment according to claim 1 or 2, wherein said determining a flow coefficient of the process gas relative to the reference gas comprises:
obtaining a reference gas timing time required for the reference gas to enable a vacuum chamber of a vacuum coating equipment to reach a second set vacuum degree from a first set vacuum degree;
obtaining a process gas timing time required for the process gas to enable the vacuum chamber of the vacuum coating equipment to reach the second set vacuum degree from the first set vacuum degree; and
taking a ratio of the process gas timing time to the reference gas timing time as the flow coefficient of the process gas relative to the reference gas.

4. The method of adjusting a process gas flow of a vacuum coating equipment according to claim 3, wherein obtaining the reference gas timing time or the process gas timing time comprises the following steps:
opening a sucking valve of the vacuum chamber to exhaust gas in the vacuum chamber to reach a background vacuum degree;
closing the sucking valve, opening an inflation valve of the reference gas or the process gas, and inflating the vacuum chamber; and
starting timing when the vacuum chamber reaches the first set vacuum degree, not stopping timing until the vacuum chamber reaches the second set vacuum degree, and taking the obtained timing time as the reference gas timing time or the process gas timing time.

5. The method of adjusting a process gas flow of a vacuum coating equipment according to claim 4, wherein obtaining the reference gas timing time or the process gas timing time further comprises the following steps:
closing the inflation valve when the vacuum chamber reaches the second set vacuum degree; and
opening the sucking valve, and closing the sucking valve after evacuating the vacuum chamber to reach the background vacuum degree.

6. The method of adjusting a process gas flow of a vacuum coating equipment according to any one of claims 1 to 5, wherein the reference gas is any one of the process gases.

7. The method of adjusting a process gas flow of a vacuum coating equipment according to any one of claims 1 to 6, wherein the reference gas is any one of argon, hydrogen, oxygen and silane.

8. The method of adjusting a process gas flow of a vacuum coating equipment according to any one of claims 1 to 7, the method further comprising: judging whether the flow coefficient of the process gas with respect to the reference gas is in a range of 0.8 to 1.2; if the judgment result is no, overhauling the equipment or resetting the process parameters until a re-determined flow coefficient of the process gas with respect to the reference gas is in the range of 0.8 to 1.2.

9. The method of adjusting a process gas flow of a vacuum coating equipment according to any one of claims 1 to 8, wherein the vacuum coating equipment is a Plasma Enhanced Chemical Vapor Deposition, PECVD, equipment or a Chemical Vapor Deposition, CVD, equipment.

10. A system of adjusting a process gas flow of a vacuum coating equipment, the system comprising: a setting unit, a flow coefficient determining unit, a flow correction unit, and a flow adjustment unit;
the setting unit being arranged to obtain a flow set value of a process gas and select a reference gas;
the flow coefficient determining unit being arranged to determine a flow coefficient of the process gas relative to the reference gas;
the flow correction unit being arranged to calculate a corrected flow value of the process gas according to the flow set value and the flow coefficient; and
the flow adjustment unit being arranged to judge whether the corrected flow value is greater than a maximum value of a range of a gas flowmeter of the vacuum coating equipment, if a judgment result is yes, alarming an over range, and executing a process program with the maximum value in the range of the gas flowmeter as a flow control value of the process gas, if the judgment result is no, taking the corrected flow value as the flow control value of the process gas.

11. The system of adjusting a process gas flow of a vacuum coating equipment according to claim 10, wherein the flow coefficient determining unit comprises a first timing module and a second timing module;
the first timing module being arranged to time a reference gas timing time required for the reference gas to enable a vacuum chamber of the vacuum coating equipment to reach a second set vacuum degree from a first set vacuum degree;
the second timing module being arranged to time a process gas timing time required for the process gas to enable the vacuum chamber of the vacuum coating equipment to reach the second set vacuum degree from the first set vacuum degree.

12. The system of adjusting a process gas flow of a vacuum coating equipment according to claim 11, wherein the flow coefficient determining unit further comprises: a vacuum degree setting unit;
the vacuum degree setting unit being arranged to set the first set vacuum degree and the second set vacuum degree.

13. The system of adjusting a process gas flow of a vacuum coating equipment according to claim 11 or 12, the system further comprising: a control module and a calculation module;
the control module being arranged to open a sucking valve of the vacuum chamber, exhausting gas in the vacuum chamber to reach a background vacuum degree; and closing the sucking valve after the vacuum chamber reaches the background vacuum degree, opening an inflation valve of the reference gas or the process gas, and inflating the vacuum chamber at a set flow;
the calculation module being arranged to determine a flow coefficient of the process gas relative to the reference gas by calculating a ratio of the process gas timing time to the reference gas timing time.

14. The system of adjusting a process gas flow of a vacuum coating equipment according to any one of claims 10 to 13, wherein the vacuum coating equipment is a Plasma Enhanced Chemical Vapor Deposition, PECVD, equipment or a Chemical Vapor Deposition, CVD, equipment.
